# FASCICULE DE BREVET EUROPEEN

(11) **EP 3 896 469 B1**
(45) Date de publication et mention de la délivrance du brevet: **20.07.2022**
(21) Numéro de dépôt: 21164033.9
(22) Date de dépôt: 22.03.2021
(51) Int. Cl.: G01R 31/12, G01R 31/52, H01B 17/02

(54) **ISOLATEUR DE LIGNE ELECTRIQUE AERIENNE COMPRENANT UN DISPOSITIF DE MESURE DE COURANT DE FUITE A AUTONOMIE PROLONGEE**
ISOLATOR FÜR ELEKTRISCHE HOCHSPANNUNGSLEITUNGEN MIT EINER LECKSTROMMESSEINRICHTUNG MIT VERLÄNGERTER REICHWEITE
OVERHEAD POWER LINE INSULATOR COMPRISING A DEVICE FOR MEASURING LEAKAGE CURRENT WITH EXTENDED AUTONOMY

(30) Priorité: 16.04.2020 FR 2003829
(43) Date de publication de la demande: 20.10.2021
(73) Titulaire: Sediver, 92400 Courbevoie (FR)
(72) Inventeur: BROCARD, Emmanuel, 63410 CHARBONNIERES LES VARENNES (FR); MESPLES, Fabrice, 03700 BELLERIVE SUR ALLIER (FR); CARTERON, Philippe, 03700 BELLERIVE SUR ALLIER (FR)
(74) Mandataire: IP Trust

(56) Documents cités:
- EP-A1- 2 884 292
- CN-A- 103 558 492
- CN-A- 110 261 750
- FR-A1- 2 959 066

## Description

### Domaine technique

L'invention concerne un isolateur de ligne électrique comprenant un dispositif de mesure de courant de fuite à autonomie prolongée.

L'invention concerne plus particulièrement un isolateur de ligne électrique comprenant un dispositif de détection et de mesure de courant de fuite fixé au niveau d'une ligne électrique aérienne à haute tension faisant partie d'un réseau de transport d'électricité, ce dispositif étant capable de fonctionner en autonomie pour une longue durée et d'envoyer des résultats de mesures à une station réceptrice distante.

### Technique antérieure

Un isolateur pour lignes électriques aériennes est destiné à maintenir en l'air une ligne électrique sur un pylône, tout en assurant l'isolation électrique entre ceux-ci.

Un tel isolateur se présente généralement sous la forme d'une chaine d'éléments diélectriques qui, en cours d'utilisation, sont soumis aux intempéries, pluie ou brouillard salin par exemple, et à la pollution de l'air, d'origine naturelle ou industrielle, de sorte que des grains de matière peuvent se déposer à la surface des éléments diélectriques.

Lorsque la couche de saleté devient humide, elle se transforme en électrolyte conducteur, ce qui peut donner naissance à un courant de fuite superficiel circulant à la surface de l'isolateur.

Dans ce cas, un courant de fuite élevé peut entraîner l'interruption de l'isolation électrique.

En conséquence, les opérateurs des lignes électriques cherchent à monitorer les courants de fuite superficiels sur ce type d'installation, afin d'intervenir lorsque nécessaire.

Le document de brevet EP2884292 présente un dispositif de détection de courant de fuite superficiel équipé d'une batterie, mesurant en continu le courant de fuite, et transmettant les résultats de mesure à une station distante ou à un dispositif portable, à des fins de monitorage de l'isolateur.

Afin d'augmenter l'autonomie du dispositif de détection, le document de brevet EP2884292 propose de limiter au strict minimum la quantité des données transmises et la complexité des circuits électroniques du dispositif de manière à en réduire la consommation électrique.

Le document de brevet CN 103 558 492 A divulgue un isolateur de lignes électriques aériennes comprenant un dispositif de détection d'un courant de fuite et un dispositif de transmission de données pouvant être mis en veille.

Le document de brevet CN 110 261 750 A divulgue un isolateur de lignes électriques aériennes comprenant un dispositif de détection d'un courant de fuite et un dispositif de transmission de données activés lors de la détection d'événements particuliers.

### Exposé de l'invention

Un isolateur de ligne électrique comprenant un dispositif de détection de courants de fuite de lignes aériennes est situé sur un pylône à proximité de conducteurs sous haute tension et peut n'être que rarement accessible.

Un objectif de l'invention est de diminuer la fréquence de maintenance nécessaire au bon fonctionnement d'un tel isolateur, tout en maintenant la qualité du monitorage.

A cet effet, l'invention a pour objet un isolateur de lignes électriques aériennes comprenant un dispositif de détection d'un courant de fuite et de transmission de données, qui est apte à détecter et mesurer un courant de fuite de l'isolateur, à enregistrer en mémoire informatique des valeurs d'un courant mesuré, et à transmettre des données représentatives desdites valeurs à une station distante de l'isolateur, le dispositif étant agencé de telle manière à mesurer dans un circuit de mesure un courant de fuite de l'isolateur au cours d'une première période de mesure et enregistrer en mémoire une première valeur correspondant à une intensité maximale du courant de fuite mesuré ; mesurer dans ledit circuit de mesure ledit courant de fuite au cours d'une deuxième période de mesure suivant la première période de mesure et enregistrer en mémoire une deuxième valeur correspondant à une intensité maximale du courant de fuite mesuré ; comparer la première valeur de courant à la deuxième valeur de courant ; et stopper pour une certaine durée de sommeil ledit circuit de mesure si la deuxième valeur de courant est inférieure ou égale à la première valeur de courant, puis redémarrer ledit circuit de mesure après ladite certaine durée de sommeil.

Le dispositif de détection de courants de fuite de l'isolateur selon l'invention est agencé pour gérer son comportement de façon évènementielle, c'est-à-dire tenant compte de l'évolution du courant de fuite mesuré.

Plus spécifiquement, la mesure du courant de fuite est stoppée lorsque le courant de fuite mesuré est stable ou diminue d'une période de mesure à l'autre, ce qui améliore la pertinence des mesures effectuées et entraîne une économie d'énergie et donc un allongement de l'autonomie de l'isolateur.

Le dispositif selon l'invention peut présenter les particularités suivantes :
- l'isolateur peut comprendre en outre un hygromètre et est agencé pour calculer ladite durée de sommeil en fonction d'un taux d'humidité relative mesuré par l'hygromètre;
- l'isolateur peut être agencé de manière à ce que la mesure du courant de fuite est réalisée seulement si le dispositif détecte un courant de fuite d'intensité supérieure à au moins un seuil préenregistré ;
- le dispositif peut être agencé de manière à ce que la mesure du courant de fuite est réalisée si le dispositif détecte un courant de fuite d'intensité comprise entre un premier seuil préenregistré et un deuxième seuil préenregistré supérieur au premier seuil préenregistré seulement si une moyenne de valeurs de courant mesuré est inférieure audit deuxième seuil ;
- l'isolateur est agencé de manière à transmettre des données représentatives des valeurs du courant mesuré, d'extrémums et d'une valeur moyenne des valeurs du courant mesuré ainsi qu'une valeur de comptage de ces valeurs de courant mesuré.

Ainsi, l'isolateur selon l'invention est agencé de manière à lancer une mesure de courant de fuite en fonction des conditions extérieures (hygrométrie) et des intensités présentes et passées (moyenne, intensité) du courant de fuite, s'adaptant automatiquement aux circonstances pour réaliser des mesures pertinentes évitant un fonctionnement continu énergivore qui diminuerait son autonomie.

### Brève description des figures

La présente invention sera mieux comprise et d'autres avantages apparaîtront à la lecture de la description détaillée du mode de réalisation pris à titre d'exemple nullement limitatif et illustré par les dessins annexés, brièvement décrits ci-dessous.
La figure 1 illustre un schéma d'un isolateur selon l'invention, équipé d'un dispositif électronique de détection et mesure de courant de fuite et de transmission de données.
La figure 2 est un agrandissement de l'élément diélectrique de l'extrémité supérieure de l'isolateur de la figure 1.
La figure 3 est un diagramme du dispositif électronique de la figure 1.
La figure 4 est un organigramme représentant le fonctionnement de l'isolateur de la figure 1.
La figure 5 représente une variation de l'organigramme de la figure 4.

### Description d'un mode de mise en œuvre du dispositif selon l'invention

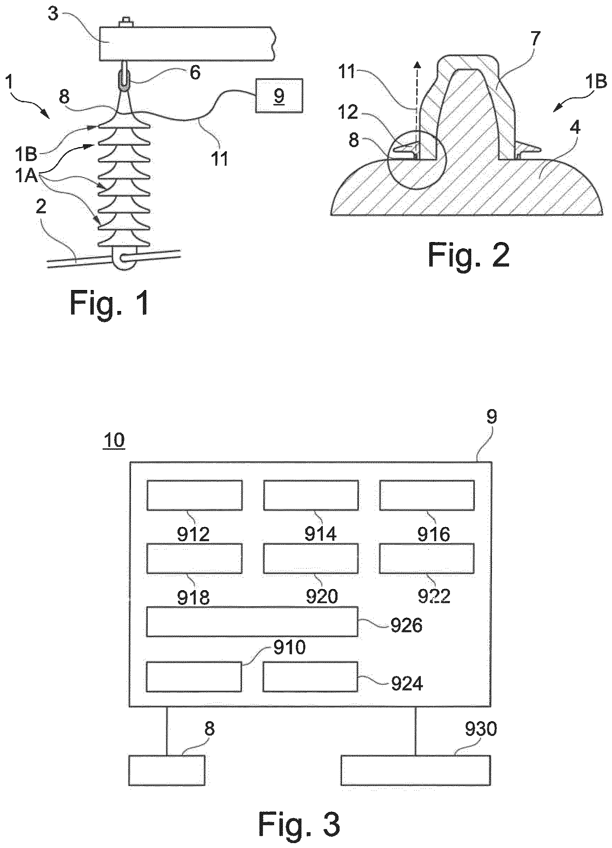

Ce mode de mise en œuvre est décrit par les figures 1 à 5.

La figure 1 illustre un schéma de l'isolateur 1 de lignes aériennes 2 selon l'invention, comprenant un dispositif 10 de détection d'un courant de fuite de l'isolateur, de mesure de ce courant et de transmission de données représentatives du courant de fuite mesuré, comprenant un module électronique 9 et un élément conducteur 8 de captage du courant de fuite, ce conducteur ayant ici la forme d'une bague métallique agencée de manière à entourer une section isolante de l'isolateur 1 comme illustré.

L'isolateur 1 de ce mode particulier de mise en œuvre est formé d'une chaîne d'éléments diélectriques 1A et 1B et est conçu pour suspendre en l'air la ligne électrique aérienne telle qu'une ligne à haute tension depuis un pylône 3.

Dans un tel isolateur, les éléments diélectriques peuvent être constitués de verre trempé comme décrit dans le document de brevet FR 3 057 697.

L'élément diélectrique 1B, situé à l'extrémité supérieure de l'isolateur 1, accueille l'élément conducteur 8 et est équipé d'un élément protecteur 12 visible sur la figure 2 protégeant l'élément conducteur 8 des intempéries à la manière d'un parapluie.

L'élément conducteur 8 est ici un anneau métallique électriquement conducteur qui est posé de façon coaxiale sur la surface extérieure 4 de l'élément diélectrique 1B de telle façon à intercepter le courant de fuite superficiel qui circule à sa surface en direction de l'armature 6 faisant l'interface entre l'isolateur 1 et le système de suspension au pylône.

L'élément conducteur 8 a ici une section carrée mais pourrait aussi avoir une section rectangulaire ou analogue ou tout autre section.

L'élément conducteur 8 a ici une base annulaire plate qui est directement en contact avec la surface extérieure 4 de l'élément diélectrique 1B.

L'élément conducteur 8 peut être collé à la surface extérieure 4 en assurant une conduction électrique à l'aide par exemple d'une colle époxy chargée en argent ou en cuivre.

Indépendamment de sa nature, de sa géométrie et de son mode de fixation à l'isolateur 1, l'élément conducteur 8 est conçu et monté sur l'isolateur 1 de manière à intercepter de préférence la plus grande proportion possible du courant de fuite, éventuellement sa totalité.

L'intensité du courant de fuite prend normalement des valeurs comprises entre quelques milliampères et quelques centaines de milliampères.

Lorsque l'on parle de valeur de l'intensité du courant de fuite, il s'agit de valeur absolue, ce courant pouvant être un courant continu ou un courant alternatif.

Un câble électrique 11 relie l'élément conducteur 8 de captage de courant de fuite au module électronique 9, éventuellement en traversant l'élément protecteur 12 puis en longeant l'armature 6.

Bien que non représenté, un autre câble électrique relie le module électronique 9 à la masse électrique afin d'y transporter le courant de fuite capté par l'élément conducteur 8.

Alternativement à l'isolateur décrit ci-dessus, l'isolateur selon l'invention pourrait avoir une structure composite, telle que celle décrite dans le document de brevet FR 3 057 697.

Quoiqu'il en soit, l'invention ne se limite pas à un type particulier d'isolateur ou de connexion au module électronique.

Comme illustré par la figure 3, le module électronique 9 du dispositif 10 comprend un circuit de mesure 910 conçu pour mesurer les courants en provenance de l'élément conducteur 8, un calculateur 912 destiné à effectuer des calculs sur les données acquises par le circuit de mesure, une mémoire informatique 914 destinée à stocker les résultats de mesure du circuit de mesure et les résultats des calculs du calculateur, un système de communication 916 destiné à transmettre les résultats des calculs du calculateur et des données stockées dans la mémoire informatique à une station réceptrice distante, une horloge 918, un hygromètre 920, un thermomètre 922, et une batterie ou une pile 924 destinée à alimenter le module en énergie.

Les éléments compris dans le dispositif électronique peuvent être sous forme d'éléments séparés connectés entre eux par des câbles électriques ou intégrés en tout ou partie au sein d'un ensemble tel qu'un circuit imprimé.

Un équipement 930 de production d'énergie tel qu'un panneau solaire et/ou une éolienne peut être agencé pour alimenter le dispositif électronique en parallèle avec la pile ou la batterie et/ou recharger cette dernière.

Il est entendu que les éléments de la figure 3 sont interconnectés de manière conventionnelle entre eux, par exemple de manière telle que l'équipement 930 et/ou la batterie ou pile 924 alimentent les autres éléments en énergie électrique et que le thermomètre et l'hygromètre délivrent au calculateur et/ou à la mémoire des données sous une forme exploitable par eux.

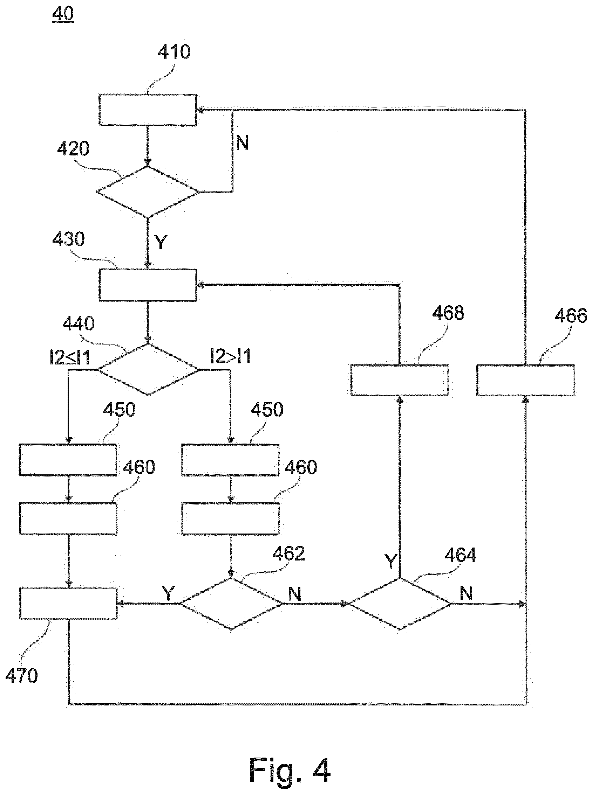

Afin d'économiser la batterie et d'augmenter son autonomie sans sacrifier la pertinence des mesures effectuées, l'isolateur selon l'invention est agencé de manière à fonctionner de la façon suivante, illustré par le diagramme 40 de la figure 4.

Le dispositif 10 comprend dans le module électronique 9 un circuit de détection 926, qui est agencé de manière à comparer la valeur du courant de fuite de l'isolateur traversant l'élément conducteur 8 de captage de courant de fuite à un ou plusieurs seuils de courant afin de détecter le dépassement de ces seuils par le courant de fuite.

En cours d'usage, le dispositif 10 est conçu de manière à maintenir par défaut un mode veille au cours d'une étape 410, le mode veille étant un mode de fonctionnement n'impliquant qu'une faible consommation d'énergie par les éléments électroniques du dispositif.

En revanche, le dispositif 10 est conçu pour entrer dans un mode mesure au cours d'une étape 430 si le circuit de détection 926 détecte (Y) que le courant de fuite dépasse un seuil de courant donné Iₛₑᵤᵢₗ au cours d'une étape de test 420, par comparaison du courant de fuite avec ce seuil de courant donné.

Un tel seuil de courant est non nul, et peut être préenregistré, sous forme numérique dans une mémoire informatique comme la mémoire 914 ou sous forme d'un ensemble d'éléments électroniques intégrés dans un circuit comme le circuit de détection 926.

Lorsque le dispositif est en mode mesure lors de l'étape 430, le circuit de mesure procède à des mesures du courant de fuite durant un cycle de mesure constitué de deux périodes de mesure successives, une première période de mesure et une deuxième période de mesure suivant immédiatement la première période de mesure.

Chacune des périodes de mesures peut durer quelques dizaines de millisecondes, le mode mesure pouvant par exemple être maintenu à 160 ms, avec une première période de mesure et une deuxième période de mesure de 80 ms chacune.

Le circuit de mesure 910, tel qu'une carte électronique de mesure et/ou d'acquisition de données, mesure et enregistre dans une première table stockée dans la mémoire informatique 914 la valeur maximale du courant de fuite mesuré traversant l'élément conducteur au cours de chacune des deux périodes de mesure : la première valeur maximale de courant Il pendant la première période de mesure et la deuxième valeur maximale de courant I2 pendant la deuxième période de mesure.

La première table est typiquement une table de deux valeurs, chacune dédiée à l'une des deux périodes de mesure.

Le calculateur compare ces deux valeurs maximales de courant l'une à l'autre au cours d'une étape de test 440 à l'issue de la deuxième période de mesure.

En réponse à la comparaison par le calculateur, le dispositif 10 est agencé pour passer en mode sommeil pour une durée de sommeil, c'est-à-dire stopper le circuit de mesure en le coupant de sa source d'alimentation énergie ou par tout autre moyen pour cette durée de sommeil au cours d'une étape 470, à la condition que la deuxième valeur maximale de courant soit inférieure ou égale à la première valeur maximale de courant (I2≤I1), puis repasser en mode veille après la durée de sommeil, c'est-à-dire redémarrer le circuit de mesure, par exemple en rétablissant son alimentation en énergie, revenant ainsi à l'étape 410.

Dans cette situation, le courant est évalué comme constant ou décroissant et on considère que surveiller le courant de fuite en continu et maintenir le circuit de mesure prêt à réagir immédiatement en cas de dépassement du seuil par le courant de fuite n'est pas nécessaire et que l'on peut se permettre de stopper le circuit pour une certaine durée dite durée de sommeil.

En réponse à la comparaison, lorsque la deuxième valeur maximale de courant est supérieure à la première valeur maximale de courant (I2>I1), le dispositif 10 est agencé pour rester en mode mesure, revenant ainsi à l'étape 430.

Dans cette situation, le courant de fuite est considéré comme croissant et on considère que maintenir sa mesure active par le circuit de mesure, est pertinent.

Il est possible d'améliorer encore la pertinence des mesures en imposant des conditions au maintien en mode mesure au moyen des deux étapes de test suivantes.

Une première étape 462 de test consiste à comparer l'état d'un compteur indiquant le nombre de cycles de mesure effectués consécutivement, c'est-à-dire sans passer par le mode veille, à un nombre seuil Nₛₑᵤᵢₗ.

Un passage dans le mode sommeil de l'étape 470 est imposé avant un retour au mode veille de l'étape 410 lorsque le compteur atteint (Y) ce nombre seuil, 10 par exemple.

Dans ce cas, le compteur est remis à zéro au cours d'une étape 466 de remise à zéro.

Tant que le compteur n'atteint pas (N) le nombre seuil Nₛₑᵤᵢₗ, une deuxième étape 464 de test est appliquée, comparant les deux valeurs maximales de courant I1 et I2 audit seuil de courant donné Iₛₑᵤᵢₗ, un passage dans le mode veille de l'étape 410 étant imposé lorsqu'aucune des valeurs des deux courants mesurés n'est supérieure (N) à ce seuil de courant.

Dans ce cas également, le compteur est remis à zéro au cours de l'étape 466 de remise à zéro.

Lorsque le compteur n'atteint pas (N) le nombre seuil Nₛₑᵤᵢₗ et qu'au moins l'une des deux valeurs I1 et I2 est supérieure ou égale (Y) audit seuil de courant donné Iₛₑᵤᵢₗ, le dispositif est ramené à l'étape 430 pour maintenir le dispositif en mode mesure et relancer un cycle de mesure.

Dans ce cas, le compteur est incrémenté de 1 au cours d'une étape 468 de suivi du nombre de cycles de mesure effectués consécutivement.

En mode sommeil, le circuit de mesure est stoppé et ne peut donc pas effectuer de mesure, même en cas de détection d'un dépassement de seuil de courant par le circuit de détection 926.

Il s'agit du mode de fonctionnement du dispositif le plus économe en énergie en raison de la mise à l'arrêt du circuit de mesure.

L'utilisation de ce mode permet donc une économie substantielle d'énergie électrique et donc d'augmenter l'autonomie du dispositif 10.

En mode veille, le circuit de mesure est alimenté en énergie électrique et est prêt à répondre à une instruction d'entrer en mode mesure et d'effectuer des mesures.

En mode mesure, le circuit de mesure est actif, c'est-à-dire qu'il est alimenté en énergie électrique et procède en outre à des mesures du courant de fuite, ce qui amène à une consommation d'énergie du dispositif 10 substantiellement plus importante que dans les autres modes.

Ainsi, dans l'isolateur selon l'invention, la mesure du courant de fuite est réalisée seulement si le dispositif détecte un courant de fuite d'intensité supérieure à un seuil donné.

Le dispositif, agencé pour mettre en œuvre la méthode de décision d'entrée en mode mesure exposée ci-dessus, bénéficie d'un excellent équilibre entre autonomie et niveau de surveillance du courant de fuite : l'autonomie est augmentée par la mise en sommeil du circuit de mesure lorsqu'une surveillance continue du courant de fuite n'apparaît pas nécessaire, mais la mesure est maintenue lorsque la probabilité de dépassement d'un seuil par le courant de fuite apparaît élevée, au vu de l'évolution du courant de fuite.

On peut fixer une durée par défaut de la période de sommeil à, typiquement, quelques minutes, 2 mn par exemple.

On peut encore optimiser l'équilibre autonomie/surveillance en utilisant des résultats de mesure de l'hygromètre : un niveau d'humidité relative bas entraîne une diminution du risque d'un courant de fuite suffisamment élevé pour entraîner une entrée en mode mesure.

Le dispositif 10 peut ainsi être agencé pour calculer, au moyen du calculateur, ladite durée de sommeil en fonction d'un taux d'humidité relative mesuré par l'hygromètre, plus spécifiquement pour augmenter la durée de sommeil lorsque le niveau d'humidité relative est bas, par exemple en passant de 2 mn par défaut à 4 mn lorsque l'humidité relative est mesurée par l'hygromètre comme inférieur à 50%.

Quoi qu'il en soit, à la suite des deux périodes de mesure du mode mesure, la valeur maximale de courant la plus haute stockée dans la première table est enregistrée dans une deuxième table de la mémoire informatique 914 au cours d'une étape 450 et la première table est réinitialisée au cours d'une étape 460.

La deuxième table a une capacité limitée à quelques centaines de valeurs, 500 par exemple.

Si le nombre de cycles de mesures effectués entraîne un dépassement du nombre de valeurs pouvant être enregistrées dans la deuxième table, une nouvelle valeur à enregistrer remplace une valeur inférieure enregistrée précédemment lorsqu'il en existe, ou bien cette nouvelle valeur n'est pas enregistrée lorsqu'elle est inférieure à toutes les valeurs remplissant la deuxième table.

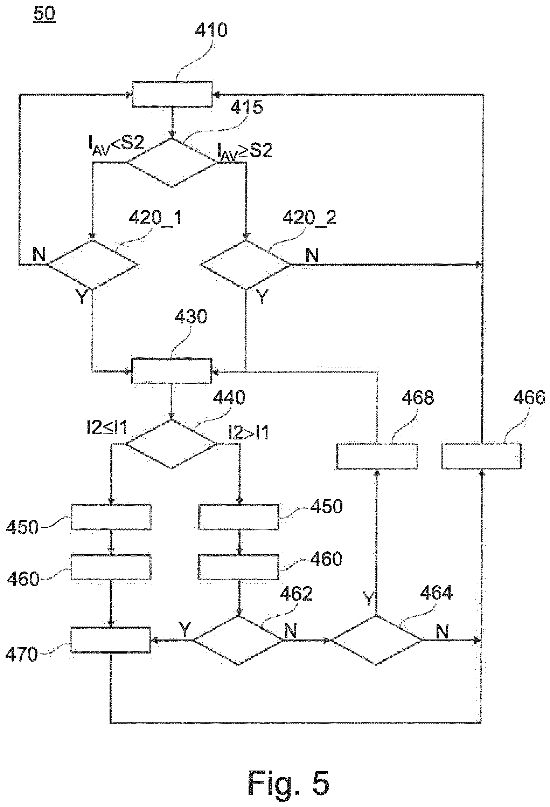

Afin d'augmenter encore l'autonomie du dispositif de mesure de courant, on peut également régler le seuil de courant à partir duquel le dispositif passe en mode mesure, c'est-à-dire à partir duquel des mesures de courant sont déclenchées, en fonction des mesures déjà effectuées, comme illustré par le diagramme 50 de la figure 5.

La description ci-dessous se concentre sur les étapes différentes de celles du diagramme 40, on peut se reporter à celui-ci et aux explications correspondantes pour les étapes de même identifiant.

Ainsi, le circuit de détection 926 peut être agencé de manière à comparer le courant traversant l'élément conducteur 8 à des seuils de courant différents selon l'historique du dispositif, historique représenté par les valeurs enregistrées dans la deuxième table.

Le circuit de détection 926 peut par exemple comprendre deux sous-circuits de détection de conception similaire mais agencés pour détecter des dépassements de seuils respectifs de courant par le courant de fuite, chacun de ces seuils étant préenregistrés comme détaillé plus haut pour l'étape 420.

Ainsi, on peut prévoir deux seuils, un premier seuil préenregistré S1 et un deuxième seuil préenregistré S2 supérieur au premier seuil préenregistré, et utiliser le premier seuil S1 par défaut, alors considéré comme seuil actif, le deuxième seuil S2 restant passif.

Dans cette description, dire d'un seuil qu'il est « actif » signifie qu'il s'agit de la valeur de référence utilisée par le module de détection 926 pour détecter le dépassement d'un seuil par le courant de fuite.

Inversement, dire d'un seuil qu'il est « passif » signifie qu'il n'est pas utilisé par le module de détection 926.

Après chaque mode mesure, on peut comparer le seuil actif à la moyenne des valeurs stockées dans la deuxième table au cours d'une étape de test 415 comme indiqué par le diagramme 50 de la figure 5, et définir le premier seuil S1 comme actif et le deuxième seuil S2 comme passif si la moyenne des valeurs enregistrées dans la deuxième table est inférieure au deuxième seuil S2.

De cette manière, si la moyenne I_{Av} des valeurs stockées dans la deuxième table est inférieure au deuxième seuil S2 (I_{AV}<S2), alors le dispositif entrera en mode mesure si le courant de fuite est détecté comme dépassant le premier seuil (Y) au cours d'une étape de test 420_1, selon le principe de l'étape 420.

Inversement, si la moyenne I_{AV} des valeurs stockées dans la deuxième table est supérieure ou égale au deuxième seuil S2 (I_{AV}≥S2), alors on peut définir le premier seuil S1 comme passif et le deuxième seuil S2 comme actif, et le dispositif entrera en mode mesure si le courant de fuite est détecté comme dépassant le deuxième seuil S2 (Y) au cours d'une étape de test 420_2, selon le principe de l'étape 420.

En résumé, l'isolateur selon l'invention est agencé de manière à ce que la mesure du courant de fuite est réalisée dans le cas où le dispositif détecte un courant de fuite d'intensité comprise entre un premier seuil S1 et un deuxième seuil S2 supérieur au premier seuil seulement si une moyenne de valeurs précédentes de courant de fuite mesuré est inférieure au deuxième seuil, une détection de dépassement du deuxième seuil par le courant de fuite entraînant systématiquement une entrée en mode mesure.

En procédant de cette manière, dans le cas d'un courant de fuite globalement important, les dépassements de seuil les plus importants sont toujours mesurés et enregistrés, mais le dispositif n'entre pas en mode mesure pour les dépassements de seuil considérés comme normaux ou négligeables au vu de l'historique représenté par la deuxième table.

Le premier seuil peut être déterminé de manière à se situer au-dessus du bruit de mesure, afin de ne considérer que les courants pouvant être détectés et mesurés de manière fiable.

Le deuxième seuil peut être défini selon l'expérience du gestionnaire de la ligne électrique monitorée au moyen de l'isolateur selon l'invention et les courants de fuite mesurés d'ordinaire.

D'un point de vue pratique, on peut ainsi assigner par exemple au premier seuil et au deuxième seuil les valeurs de 20 mA et 150 mA, respectivement.

Le traitement et la transmission des valeurs de courant de fuite mesuré décrits ci-dessus permettent de limiter le nombre d'entrées en mode mesure ainsi que, éventuellement, la quantité de données à transférer à la station distante, tout en acquérant et en transférant les données pertinentes, sur la base d'une évaluation événementielle et non continue du courant de fuite de l'isolateur.

Périodiquement, les valeurs stockées dans la deuxième table, correspondant à des extrémums du courant de fuite mesuré, leur moyenne et leur nombre sont transmis à une station réceptrice distance de l'isolateur au moyen du système de communication 916 et la deuxième table est réinitialisée.

En outre, la valeur maximale de la deuxième table, la température extérieure, l'humidité relative, la tension de la batterie ou de la pile, le nombre de détections de dépassement de courant de fuite d'intensité supérieure au premier seuil, le nombre de détections de dépassement de courant de fuite d'intensité supérieure au deuxième seuil et, le cas échéant, la tension aux bornes d'un panneau solaire peuvent être transmis à la station distante pour une meilleure évaluation du courant de fuite, de l'environnement dans lequel se situe l'isolateur monitoré et de l'état de ce dernier.

Les nombres de mesures ou de détections de dépassement de seuil de courant de fuite sont obtenus par des valeurs de comptages respectives au moyen de comptages effectués par le calculateur.

Le dispositif peut être agencé de manière à procéder à une telle transmission, typiquement, toutes les heures, ce qui permet une bonne réactivité de l'opérateur recueillant ces données sans imposer une dépense d'énergie excessive au dispositif.

Il va de soi que la présente invention ne saurait être limitée au mode de réalisation exposé plus haut, le cadre de l'invention étant défini dans les revendications.

## Revendications

1. Isolateur (1) de lignes électriques aériennes comprenant un dispositif (10) de détection d'un courant de fuite et de transmission de données, qui est apte à détecter et mesurer un courant de fuite de l'isolateur, à enregistrer en mémoire informatique des valeurs d'un courant mesuré, à transmettre des données représentatives desdites valeurs à une station distante de l'isolateur, et qui est agencé de telle manière à :
- mesurer (430) dans un circuit de mesure (910) un courant de fuite de l'isolateur au cours d'une première période de mesure et enregistrer en mémoire (914) une première valeur correspondant à une intensité maximale du courant de fuite mesuré ; et
- mesurer (430) dans ledit circuit de mesure (910) ledit courant de fuite au cours d'une deuxième période de mesure suivant la première période de mesure et enregistrer en mémoire (914) une deuxième valeur correspondant à une intensité maximale du courant de fuite mesuré , l'isolateur de lignes électriques aériennes étant **caractérisé en ce que** le dispositif est en outre agencé de telle manière à :
- comparer (440) la première valeur de courant à la deuxième valeur de courant ; et
- stopper (470) pour une certaine durée de sommeil ledit circuit de mesure si la deuxième valeur de courant est inférieure ou égale à la première valeur de courant, puis redémarrer ledit circuit de mesure après ladite certaine durée de sommeil.

2. L'isolateur selon la revendication 1, **caractérisé en ce que** le dispositif comprend en outre un hygromètre (920) et est agencé pour calculer ladite durée de sommeil en fonction d'un taux d'humidité relative mesuré par l'hygromètre.

3. L'isolateur selon la revendication 1 ou 2, **caractérisé en ce que** le dispositif est agencé de manière à ce que la mesure du courant de fuite est réalisée seulement si le dispositif détecte un courant de fuite d'intensité supérieure à au moins un seuil préenregistré.

4. L'isolateur selon la revendication 1 ou 2, **caractérisé en ce que** le dispositif est agencé de manière à ce que la mesure du courant de fuite est réalisée si le dispositif détecte un courant de fuite d'intensité comprise entre un premier seuil préenregistré et un deuxième seuil préenregistré supérieur au premier seuil préenregistré seulement si une moyenne de valeurs de courant mesuré est inférieure audit deuxième seuil préenregistré.

5. L'isolateur selon l'une quelconque des revendications 1 à 4, **caractérisé en ce que** le dispositif est agencé de manière à transmettre des données représentatives des valeurs du courant mesuré, d'extrémums et d'une valeur moyenne des valeurs du courant mesuré ainsi qu'une valeur de comptage de ces valeurs de courant mesuré.

## Patentansprüche

1. Isolator (1) für Freileitungen, der eine Vorrichtung (10) zum Erfassen eines Leckstroms und zum Übertragen von Daten umfasst, die geeignet ist, um einen Leckstrom des Isolators zu erfassen und zu messen, um Werte eines gemessenen Stroms in einem Computerspeicher zu speichern, um Daten, die die Werte darstellen, an eine von dem Isolator entfernte Station zu übertragen, und die so angeordnet ist, dass sie:
- in einem Messkreis (910) einen Leckstrom des Isolators während einer ersten Messperiode misst (430) und in einem Speicher (914) einen ersten Wert speichert, der einer maximalen Stromstärke des gemessenen Leckstroms entspricht; und
- in dem Messkreis (910) den Leckstrom während einer zweiten Messperiode, die auf die erste Messperiode folgt, misst (430) und einen zweiten Wert, der einer maximalen Stromstärke des gemessenen Leckstroms entspricht, in einem Speicher (914) speichert,
wobei der Isolator für Freileitungen **dadurch gekennzeichnet ist, dass** die Vorrichtung ferner so angeordnet ist, dass sie:
- den ersten Stromwert mit dem zweiten Stromwert vergleicht (440); und
- den Messkreis für eine bestimmte Schlafdauer anhält (470), wenn der zweite Stromwert kleiner oder gleich dem ersten Stromwert ist, und dann der Messkreis nach der bestimmten Schlafdauer wieder startet.

2. Isolator nach Anspruch 1, **dadurch gekennzeichnet, dass** die Vorrichtung ferner ein Hygrometer (920) umfasst und zum Berechnen der Schlafdauer auf der Grundlage eines durch das Hygrometer gemessenen relativen Feuchtigkeitsgehalts angeordnet ist.

3. Isolator nach Anspruch 1 oder 2, **dadurch gekennzeichnet, dass** die Vorrichtung so angeordnet ist, dass die Messung des Leckstroms nur dann durchgeführt wird, wenn die Vorrichtung einen Leckstrom einer Stromstärke erfasst, die höher als wenigstens ein vorab gespeicherter Schwellenwert ist.

4. Isolator nach Anspruch 1 oder 2, **dadurch gekennzeichnet, dass** die Vorrichtung so angeordnet ist, dass die Messung des Leckstroms nur dann durchgeführt wird, wenn die Vorrichtung einen Leckstrom einer Stromstärke zwischen einem ersten vorab gespeicherten Schwellenwert und einem zweiten vorab gespeicherten Schwellenwert erfasst, die höher als der erste vorab gespeicherte Schwellenwert ist, wenn ein Mittelwert der gemessenen Stromwerte kleiner als der zweite vorab gespeicherte Schwellenwert ist.

5. Isolator nach einem der Ansprüche 1 bis 4, **dadurch gekennzeichnet, dass** die Vorrichtung so angeordnet ist, dass sie Daten überträgt, die die gemessenen Stromwerte, Extremwerte und einen Mittelwert der gemessenen Stromwerte sowie einen Zählwert dieser gemessenen Stromwerte darstellen.

## Claims

1. An insulator (1) for overhead power lines comprising a leakage current detection and data transmission device (10) which is suitable for detecting and measuring a leakage current of the insulator, recording values of a measured current in a computer memory, and transmitting data representing said values to a station that is remote from the insulator, said device being arranged in such a way as to:
- measure (430) in a measurement circuit (910) a leakage current of the insulator during a first measurement period and record in a memory (914) a first value corresponding to a maximum intensity of the measured leakage current; and
- measure (430) in said measurement circuit (910) said leakage current during a second measurement period following the first measurement period and record in the memory (914) a second value corresponding to a maximum intensity of the measured leakage current,
the overhead power line insulator being **characterized in that** the device is further arranged in such a way as to:
- compare (440) the first current value with the second current value; and
- stop (470) said measurement circuit for a certain sleep time if the second current value is less than or equal to the first current value, then restart said measurement circuit after said certain sleep time.

2. The insulator according to claim 1, **characterized in that** the device further comprises a hygrometer (920) and is arranged to calculate said sleep time on the basis of a relative humidity level measured by the hygrometer.

3. The insulator according to claim 1 or 2, **characterized in that** the device is arranged in such a way that the measurement of the leakage current is carried out only if the device detects a leakage current of intensity greater than at least one pre-recorded threshold.

4. The insulator according to claim 1 or 2, **characterized in that** the device is arranged in such a way that the measurement of the leakage current is carried out if the device detects a leakage current of an intensity between a first pre-recorded threshold and a second pre-recorded threshold greater than the first pre-recorded threshold only if an average of measured current values is less than said second pre-recorded threshold.

5. The insulator according to any of claims 1 to 4, **characterized in that** the device is arranged in such a way as to transmit data representing the values of the measured current, the extrema, and an average of the values of the measured current, as well as a count value of these measured current values.
